# EUROPEAN PATENT APPLICATION

(11) **EP 4 697 879 A1**
(43) Date of publication of application: **18.02.2026**
(21) Application number: 24848120.2
(22) Date of filing: 24.07.2024
(51) Int. Cl.: H05K 7/20

(54) **VAPOR CHAMBER AND ELECTRONIC DEVICE**

(30) Priority: 31.07.2023 CN 202310962665
(71) Applicant: Huawei Technologies Co., Ltd., Shenzhen, Guangdong 518129 (CN)
(72) Inventor: ZHU, Mingchao, Shenzhen, Guangdong 518129 (CN); YANG, Junjian, Shenzhen, Guangdong 518129 (CN); ZHEN, Haitao, Shenzhen, Guangdong 518129 (CN); ZOU, Liujun, Shenzhen, Guangdong 518129 (CN)
(74) Representative: Gill Jennings & Every LLP
(86) International application number: PCT/CN2024/107367
(87) International publication number: WO 2025/026163

(57) **Abstract**

This application relates to a vapor chamber and an electronic device. The vapor chamber is used in the electronic device. The vapor chamber includes a first cover plate, a second cover plate, and a capillary structure. An edge of the first cover plate is fastened to an edge of the second cover plate, to form a closed cavity between the first cover plate and the second cover plate. The capillary structure is located in the cavity, and the capillary structure is configured to guide flow of liquid in the cavity. The cavity includes a first cavity and a second cavity that communicate with each other, the first cavity is located in a first area of the vapor chamber, the second cavity is located in a second area of the vapor chamber, and the first area is used to connect to a heating element of the electronic device. A size of the second cavity in a first direction is greater than a size of the first cavity in the first direction, and the first direction is an arrangement direction of the first cover plate and the second cover plate. In embodiments of this application, the size of the second cavity is increased, so that air resistance of gas in the second cavity is small, and a through-flow capability of the gas is increased. This facilitates timely and rapid diffusion of the gas to the second cavity, and improves a heat dissipation capability of the vapor chamber.

## Description

This application claims priority to Chinese Patent Application No. 202310962665.X, filed with the China National Intellectual Property Administration on July 31, 2023 and entitled "VAPOR CHAMBER AND ELECTRONIC DEVICE", which is incorporated herein by reference in its entirety.

### TECHNICAL FIELD

The present invention relates to the field of heat dissipation technologies, and in particular, to a vapor chamber and an electronic device.

### BACKGROUND

The development of electronic devices has changed our lifestyle. In particular, the development of tablets, foldable computers, and foldable mobile phones has brought great convenience to our life.

A vapor chamber is usually disposed in an electronic device, and is configured to dissipate heat for the electronic device. The existing vapor chamber has low heat dissipation efficiency and a limited heat dissipation capability, which restricts performance improvement of the electronic device. Therefore, how to optimize a design of the vapor chamber to improve the heat dissipation capability of the vapor chamber is critical.

### SUMMARY

Embodiments of this application provide a vapor chamber and an electronic device. In this application, different areas of the vapor chamber are disposed with different sizes, to improve a heat dissipation capability of the vapor chamber.

According to a first aspect, an embodiment of this application provides a vapor chamber, used in an electronic device. A vapor chamber includes a first cover plate, a second cover plate, and a capillary structure. An edge of the first cover plate is fastened to an edge of the second cover plate, to form a closed cavity between the first cover plate and the second cover plate. The capillary structure is located in the cavity, and the capillary structure is configured to guide flow of liquid in the cavity. The cavity includes a first cavity and a second cavity that communicate with each other, the first cavity is located in a first area of the vapor chamber, the second cavity is located in a second area of the vapor chamber, and the first area is used to connect to a heating element of the electronic device. A size of the second cavity in a first direction is greater than a size of the first cavity in the first direction, and the first direction is an arrangement direction of the first cover plate and the second cover plate. It may be understood that the first area may be in contact with and fastened to the heating element, or another mechanical part may be disposed between the first area and the heating element, and the first area is connected to the heating element via the another mechanical part.

It may be understood that the second area is disposed away from the heating element relative to the first area. The first area may be fastened to the heating element. Heat energy of the heating element is transferred to the first area, and a liquid working medium in the first area is vaporized into gas. The gas fills the cavity. After the gas is in contact with the second area that has a low temperature, the gas is liquefied into liquid. In addition, the heat energy is dissipated. The liquid liquefied in the second area flows back to the first area under a capillary force of the capillary structure, and continues to be vaporized in the first area. The process is repeated to implement continuous heat dissipation.

It may be understood that the size of the cavity in the first direction may be a spacing between structures that form the cavity and that are enclosed in the first direction. For example, the size of the first cavity in the first direction may be a spacing that is between the first cover plate and the second cover plate and that corresponds to the first area, and the size of the second cavity in the first direction may be a spacing that is between the first cover plate and the second cover plate and that corresponds to the second area.

In this embodiment of this application, the size of the second cavity in the first direction is set to be greater than the size of the first cavity in the first direction, compared with a design in which the size of the first cavity is equal to the size of the second cavity in the first direction, in this embodiment of this application, the size of the second cavity is increased, so that air resistance of gas in the second cavity is small, and a through-flow capability of the gas is increased. This facilitates timely and rapid diffusion of the gas to the second cavity, and helps improve heat dissipation efficiency to improve a heat dissipation capability of the vapor chamber.

In a possible implementation, in the first direction, a size of a part that is of the capillary structure and that is located in the second area is greater than a size of a part that is of the capillary structure and that is located in the first area. A size of the capillary structure in the first direction may be understood as a thickness of the capillary structure. In this embodiment of this application, the size of the second cavity in the first direction is set to be greater than the size of the first cavity in the first direction, so that space of the second cavity is increased, and a capillary structure with a thicker thickness may be disposed in the second cavity with larger space, to increase the capillary force of the capillary structure in the second cavity, and increase a liquid backflow capability in the second cavity. When an anti-gravity problem occurs (the anti-gravity problem may be understood as that a direction of gravity of the liquid in the second cavity is different from a direction of the capillary force of the capillary structure, and the liquid cannot overcome the gravity of the liquid and flows back to the first cavity through the capillary force), the liquid accumulates in the second cavity, which affects the liquid to flow back to the first cavity, and reduces a heat dissipation capability of the vapor chamber. In this embodiment of this application, the capillary structure with a thicker thickness is disposed in the second cavity with larger space, so that a capillary force of the capillary structure in the second cavity is increased, and even in an anti-gravity scenario, the liquid can overcome gravity of the liquid to implement backflow.

In a possible implementation, the capillary structure includes a capillary mesh and a capillary fiber, the capillary mesh is fastened to the second cover plate, and the capillary fiber is fastened to a side that is of the capillary mesh and that faces the first cover plate; and in the first direction, a size of a part that is of the capillary fiber and that is located in the second area is greater than a size of a part that is of the capillary fiber and that is located in the first area; or in the first direction, a size of a part that is of the capillary mesh and that is located in the second area is greater than a size of a part that is of the capillary mesh and that is located in the first area. The capillary mesh may be a porous mesh structure, and is configured to provide the capillary force for the capillary structure. The capillary fiber may be configured to drain liquid and improve the capillary force of the capillary structure. The size of the capillary fiber in the first direction may be understood as a thickness of the capillary fiber, and the size of the capillary mesh in the first direction may be understood as a thickness of the capillary mesh. In this embodiment of this application, the thickness of the part that is of the capillary fiber or the capillary mesh and that is in the second area are increased to increase the thickness of the capillary structure in the second area. This helps provide a sufficient capillary force for liquid in the second cavity, facilitates liquid backflow, and resolves an anti-gravity problem.

In a possible implementation, the capillary structure includes a capillary mesh and a capillary fiber, the capillary mesh is fastened to the second cover plate, the capillary fiber is fastened to a side that is of the capillary mesh and that faces the first cover plate, and a width of a part that is of the capillary fiber and that is in the second area is greater than a width of a part that is of the second capillary fiber and that is in the first area. In this embodiment of this application, the width of the part that is of the capillary fiber and that is in the second area may be increased to increase the capillary force of the capillary structure in the second area. This helps provide a sufficient capillary force for the liquid in the second cavity, facilitates liquid backflow, and resolves an anti-gravity problem.

In a possible implementation, the cavity includes a third cavity, the third cavity communicates with the first cavity and the second cavity, and the third cavity is located in a third area of the vapor chamber; and the third area is used for heat dissipation, a size of the third cavity in the first direction is greater than or equal to a size of the first cavity in the first direction. The size of the third cavity in the first direction may be a spacing that is between the first cover plate and the second cover plate and that corresponds to the third area. When the size of the third cavity in the first direction is greater than the size of the first cavity in the first direction, compared with a design in which the size of the first cavity is equal to the size of the third cavity in the first direction, in this embodiment of this application, the size of the third cavity is increased, so that air resistance of gas in the third cavity is small, and a through-flow capability of the gas is increased. This facilitates timely and rapid diffusion of the gas to the third cavity, and helps improve heat dissipation efficiency to improve a heat dissipation capability of the vapor chamber.

In a possible implementation, the capillary structure includes a capillary mesh and a capillary fiber, the capillary mesh is fastened to the second cover plate, the capillary fiber is fastened to a side that is of the capillary mesh and that faces the first cover plate, and a quantity of capillary fibers in the second area is greater than or equal to two. When there is an anti-gravity problem in the second area, the quantity of capillary fibers in the second area is set to be greater than or equal to two. This helps provide a sufficient capillary force for liquid in the second cavity, facilitates liquid backflow, and resolves the anti-gravity problem.

In a possible implementation, the cavity includes a third cavity, the third cavity communicates with the first cavity and the second cavity, and the third cavity is located in a third area of the vapor chamber; and the vapor chamber includes a partition member, and the partition member is located between the second cavity and the third cavity and is configured to isolate the second cavity from the third cavity. It may be understood that the third area is disposed away from the heating element relative to the first area. The first area, the second area, and the third area may be in a form of a "Y"-shaped structure, a "T"-shaped structure, or the like. The first area may be fastened to the heating element. Heat energy of the heating element is transferred to the first area, and the liquid working medium in the first area is vaporized into gas. The gas fills the cavity. After the gas is in contact with the second area and the third area that have a low temperature, the gas is liquefied into liquid. In addition, the heat energy is dissipated. The liquid liquefied in the second area and the third area flows back to the first area under the capillary force of the capillary structure, and continues to be vaporized in the first area. The process is repeated to implement continuous heat dissipation. The partition member may be a hollow structure, to reduce a weight of the vapor chamber and implement lightweight. Alternatively, the partition member may be a solid structure. In an anti-gravity scenario, when the second cavity has an anti-gravity problem, a part of liquid in the third cavity flows to the second cavity under an action of gravity of the liquid. As a result, the liquid accumulates in the second cavity, it is more difficult for the liquid in the second cavity to flow back, and a heat dissipation capability of the vapor chamber is reduced. In this embodiment of this application, the partition member is disposed between the second cavity and the third cavity, to isolate the second cavity from the third cavity, and to prevent liquid in the third cavity from flowing to the second cavity, so that the liquid in the third cavity flows back to the first cavity. This implements cyclic heat dissipation.

In a possible implementation, a surface that is of the partition member and that faces the second cavity is an arc-shaped surface, or a surface that is of the partition member and that faces the third cavity is an arc-shaped surface. When the surface that is of the partition member and that faces the third cavity is an arc-shaped surface, liquid in the third cavity may flow to the first cavity along the arc-shaped surface. This avoids a problem that, when the surface that is of the partition member and that faces the third cavity is a surface with a large bending angle, liquid accumulates seriously at the partition member and cannot flow back to the first cavity in time. In addition, the arc-shaped surface can reduce resistance to the gas, the surface that is of the partition member and that faces the second cavity is an arc-shaped surface, and the surface that is of the partition member and that faces the third cavity is an arc-shaped surface. This can prevent the partition member from affecting diffusion of gas, to affect heat dissipation effect of the vapor chamber.

In a possible implementation, the partition member includes a first end and a second end that are disposed opposite to each other, the first end is closer to the first area than the second end, a size of the first end in a second direction is less than a size of the second end in the second direction, and the second direction is perpendicular to the first direction. A width of the first end is smaller than a width of the second end. This helps liquid quickly flow to the first end along the second end and converge in the first area, and improves a heat dissipation capability of the vapor chamber.

In a possible implementation, the capillary structure includes the capillary mesh and the capillary fiber, the capillary mesh is fastened to the second cover plate, the capillary fiber is fastened to the side that is of the capillary mesh and that faces the first cover plate, one side of the partition member abuts against the first cover plate, and the other side of the partition member abuts against the capillary mesh. The partition member abuts between the capillary mesh and the first cover plate, to help separate the first cavity from the second cavity.

In a possible implementation, the partition member and the first cover plate are an integrated structure. The partition member and the first cover plate are the integrated structure, so that a process of fastening the partition member to the first cover plate can be omitted; and the partition member and the first cover plate are the integrated structure, so that the first cover plate and the partition member are closely connected to each other. This prevents liquid in the third cavity from flowing to the second cavity due to a gap generated because the first cover plate and the partition member are not tightly connected.

In a possible implementation, the capillary structure includes a capillary mesh and a first capillary fiber, the capillary mesh is fastened to the second cover plate, the first capillary fiber is fastened to a side that is of the capillary mesh and that faces the first cover plate, and at least a part of the first capillary fiber is located in the second area; and the second area includes a first side and a second side, a temperature on the first side is lower than a temperature on the second side, and a part that is of the second capillary fiber and that is located in the second area is located on the first side. In an anti-gravity scenario, when the second cavity has an anti-gravity problem, the first capillary fiber is disposed on the first side with a lower temperature, to facilitate rapid backflow of liquid in the second cavity, and to prevent liquid from accumulating in the second cavity. This can effectively resolve the anti-gravity problem. It may be understood that, compared with the second side with a higher temperature, the gas is more likely to be liquefied into liquid on the first side with the lower temperature. The first capillary fiber is disposed on the first side on which the gas is more likely to be liquefied, the liquid liquefied on the first side can quickly flow back to the first cavity in time.

In a possible implementation, the cavity includes a third cavity, the third cavity communicates with the first cavity and the second cavity, and the third cavity is located in a third area of the vapor chamber; the capillary structure further includes a second capillary fiber, and at least a part of the second capillary fiber is located in the third area; and the third area includes a third side and a fourth side, a temperature on the third side is lower than a temperature on the fourth side, and a part that is of the second capillary fiber and that is located in the third area is located on the fourth side. The first capillary fiber is located on the first side with the lower temperature, and the second capillary fiber is located on the fourth side with a higher temperature, so that the first capillary fiber and the second capillary fiber are arranged in a staggered manner, and the second capillary fiber isolates the second cavity from the third cavity. This prevents a part of liquid in the third cavity from flowing to the second cavity, helps the liquid in the third cavity flow back to the first cavity, and improves a heat dissipation capability of the vapor chamber. In addition, the first capillary fiber and the second capillary fiber are arranged in a staggered manner, to isolate the second cavity from the third cavity. This facilitates completion of a vacuumizing process, can improve a vacuum degree in the cavity, and improve a heat dissipation capability of the vapor chamber.

In a possible implementation, a material of the first cover plate or the second cover plate is at least one of stainless steel, copper, and titanium. In this embodiment of this application, the cavity formed by the first cover plate and the cavity formed by the second cover plate have different thicknesses in different areas. In other words, the first cover plate or the second cover plate is an uneven structure, and may be formed through stamping. The first cover plate or the second cover plate needs to have high-strength performance, the material of the first cover plate or the second cover plate is set to at least one of high-strength stainless steel, copper, or titanium. This facilitates processing of the vapor chamber.

In a possible implementation, the first area is used for heat absorption, and the second area is used for heat dissipation.

According to a second aspect, this application provides an electronic device, including a heating element and the vapor chamber according to any one of the foregoing implementations. The heating element is connected to the vapor chamber, and heat energy of the heating element is conducted to the vapor chamber. The electronic device may be a tablet, a foldable computer, a foldable mobile phone, or the like. The heating element may be a central processing unit or the like.

### BRIEF DESCRIPTION OF DRAWINGS

To describe technical solutions in embodiments of the present invention or in the background more clearly, the following briefly describes accompanying drawings for describing embodiments of the present invention or the background.
FIG. 1 is a diagram of a structure of an electronic device according to an implementation of this application;
FIG. 2 is a diagram of another structure of an electronic device according to an implementation of this application;
FIG. 3 is a diagram of a structure of the electronic device shown in FIG. 1 when being placed horizontally;
FIG. 4 is a diagram of an internal structure of the electronic device shown in FIG. 1;
FIG. 5 is a diagram of a heat dissipation principle of a vapor chamber according to an implementation of this application;
FIG. 6 is a diagram of a structure of a vapor chamber shown in FIG. 1;
FIG. 7 is a diagram of an exploded structure of the vapor chamber shown in FIG. 6;
FIG. 8 is a side view of the vapor chamber shown in FIG. 6;
FIG. 9 is a diagram of a structure formed with a cavity of a vapor chamber according to an implementation of this application;
FIG. 10 is a diagram of another structure formed with a cavity of a vapor chamber according to an implementation of this application;
FIG. 11 is a principle diagram of circulation of liquid and gas inside a vapor chamber according to an implementation of this application;
FIG. 12 is a diagram of a partial structure of the vapor chamber shown in FIG. 6;
FIG. 13 is a diagram of a partial internal structure of the vapor chamber shown in FIG. 6 from an angle;
FIG. 14 is a diagram of an internal structure of the vapor chamber shown in FIG. 6 from another angle;
FIG. 15 is a diagram of a partial structure of another vapor chamber according to an implementation of this application;
FIG. 16 is a diagram of an internal structure of a vapor chamber according to an implementation of this application;
FIG. 17 is a diagram of a structure of a first cover plate according to an implementation of this application;
FIG. 18 is a diagram of an internal structure of another vapor chamber according to an implementation of this application;
FIG. 19 is a diagram of a partial structure of another vapor chamber according to an implementation of this application;
FIG. 20 is a diagram of an internal structure of another vapor chamber according to an implementation of this application;
FIG. 21 is a diagram of a partial structure of another vapor chamber according to an implementation of this application;
FIG. 22 is a diagram of an internal structure of another vapor chamber according to an implementation of this application;
FIG. 23 is a diagram of a structure of another vapor chamber according to an implementation of this application; and
FIG. 24 is a diagram of a structure of another vapor chamber according to an implementation of this application.

### DESCRIPTION OF EMBODIMENTS

The following clearly and completely describes technical solutions in embodiments of this application with reference to accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

It should be understood that "first", "second", and the like used in this application are merely used for distinguishing and description, but cannot be understood as an indication or implication of relative importance or an indication or implication of a sequence.

In the descriptions of this application, an orientation or a location relationship indicated by the term "up", "down", "left", "right", or the like is an orientation or a location relationship based on the accompanying drawings, and is merely intended for ease of describing this application and simplifying description, but does not indicate or imply that a specified apparatus or element needs to have a specific orientation or needs to be constructed and operated in a specific orientation. Therefore, such terms cannot be understood as a limitation on this application.

In the descriptions of this application, it should be noted that, unless otherwise clearly specified and limited, the term "connection" should be understood in a broad sense, for example, may be a fixed connection, or may be a detachable connection, or may further be an abutting connection or an integrated connection. A person of ordinary skill in the art may understand specific meanings of the foregoing terms in this application based on specific cases.

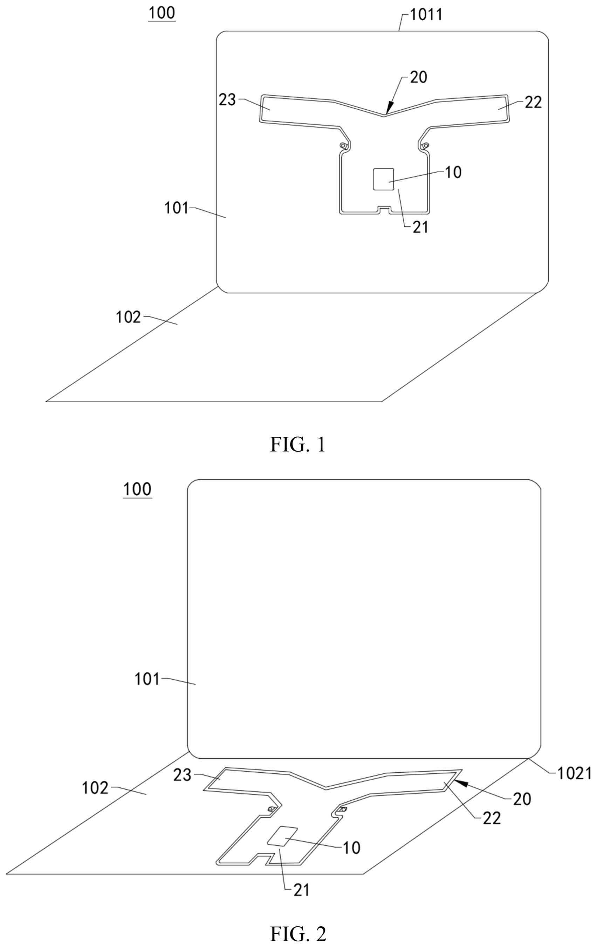

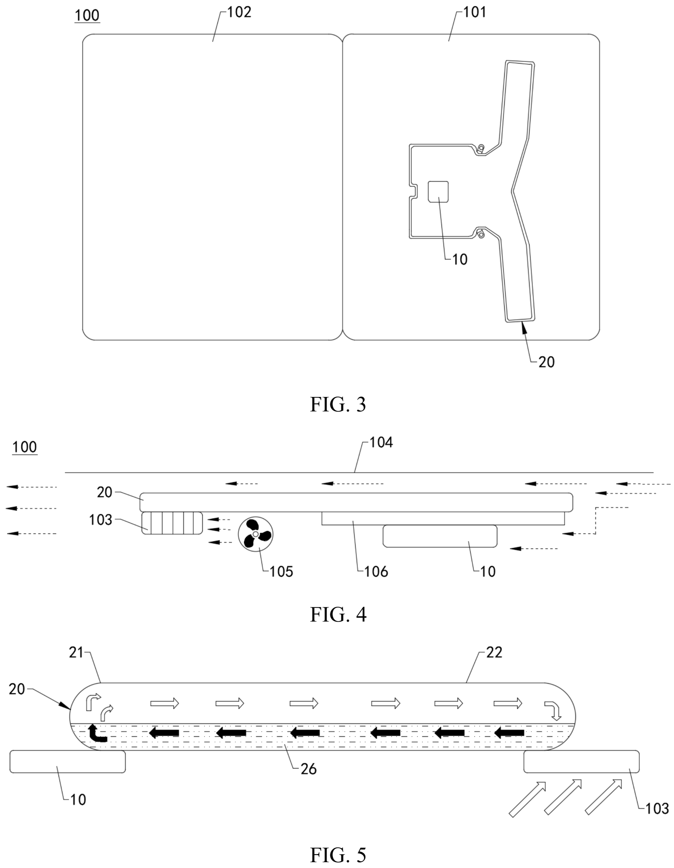

As shown in FIG. 1, FIG. 2, and FIG. 3, FIG. 1 is a diagram of a structure of an electronic device 100, FIG. 2 is a diagram of another structure of an electronic device 100, and FIG. 3 is a diagram of a structure of the electronic device 100 shown in FIG. 1 when being placed horizontally. The electronic device 100 may be a tablet, a foldable computer, a foldable mobile phone, or the like. When the electronic device 100 operates, some components inside the electronic device 100 generate heat. As heat energy generated by the electronic device 100 increases, operating performance of the electronic device 100 is affected, and user experience is reduced. In this case, the electronic device 100 needs to dissipate heat.

In embodiments of this application, an example in which the electronic device 100 is a computer is used for description. The electronic device 100 may include a first part 101 and a second part 102 that are connected to each other. The first part 101 and the second part 102 each may be a display part, and may display a text, an image, and the like. The electronic device 100 may be externally connected to a keyboard, to control display of the first part 101 and the second part 102. In another implementation, alternatively, the first part 101 may be set as a display part and is configured to display a text, an image, and the like, and the second part 102 may be a touch keyboard, to control display of the first part 101. The electronic device 100 may alternatively be in another application form. This is not limited in this application.

The electronic device 100 may include a heating element 10 and a vapor chamber 20. The heating element 10 may be fastened to the vapor chamber 20, heat energy of the heating element 10 may be transferred to the vapor chamber 20, and the vapor chamber 20 is configured to dissipate the heat energy of the heating element 10, to implement heat dissipation of the electronic device 100. The heating element 10 may be fastened to a circuit board, and the heating element 10 may be a central processing unit or the like.

As shown in FIG. 1, the heating element 10 may be located in the first part 101, the vapor chamber 20 is disposed in the first part 101 and is fastened to the heating element 10, and the vapor chamber 20 dissipates heat for the heating element 10. As shown in FIG. 2, the heating element 10 may alternatively be located in the second part 102, the vapor chamber 20 is disposed in the second part 102 and is fastened to the heating element 10, and the vapor chamber 20 dissipates heat for the heating element 10. In another implementation, the heating element 10 may be disposed in each of the first part 101 and the second part 102, there may be two vapor chambers 20, and the two vapor chambers 20 are respectively disposed in the first part 101 and the second part 102. A position of the vapor chamber 20 may be disposed based on the heating element, to effectively improve heat dissipation of the electronic device 100 in time.

The electronic device 100 in FIG. 1 to FIG. 3 is merely an example. Sizes, shapes, positions, and the like of the heating element 10 and the vapor chamber 20 may be set as required. A specific structure of the electronic device 100 is not limited in this application.

As shown in FIG. 1 and FIG. 4. FIG. 4 is a diagram of an internal structure of the electronic device 100 shown in FIG. 1. An arrow in FIG. 4 represents a wind direction. The electronic device 100 may include a heat dissipation fin 103, a rear housing 104, a heat dissipation element 105, and a fastener 106. The rear housing 104 may be provided with mounting space. The heating element 10, the vapor chamber 20, the heat dissipation fin 103, the heat dissipation element 105, and the fastener 106 are all located in the mounting space of the rear housing 104. A gap is provided between the vapor chamber 20 and the rear housing 104, and the wind in the environment may pass through the gap, to dissipate heat for the vapor chamber 20. The vapor chamber 20 is fastened to the heating element 10 via the fastener 106. The heat dissipation fin 103 is disposed in a heat dissipation area of the vapor chamber 20. An air exhaust vent of the heat dissipation element 105 (the heat dissipation element 105 may be a fan) faces the heat dissipation fin, and heat energy is taken away under an action of wind, to dissipate heat.

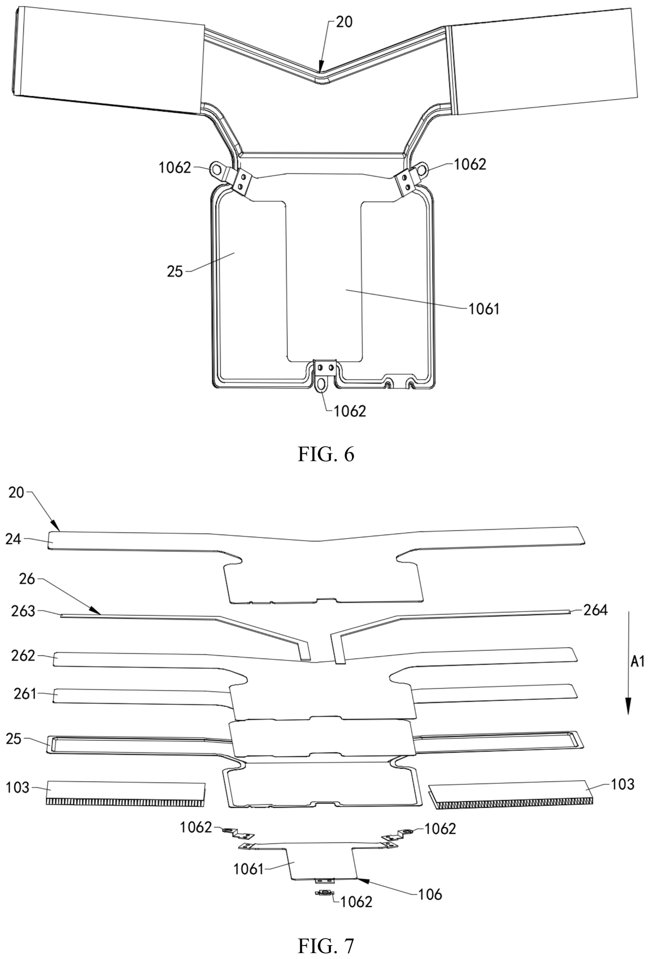

In some embodiments, the fastener 106 may include a body 1061 and spring plates 1062 (refer to subsequent FIG. 7). The body 1061 is welded to the vapor chamber 20, and the spring plates 1062 are fastened to the body 1061 and the circuit board. In this way, the body 1061 is closely attached to the heating element 10 on the circuit board, that is, the vapor chamber 20 is closely attached to the heating element 10. This helps transmit the heat energy of the heating element 10 to the vapor chamber 20 in time, and helps quickly dissipate heat for the electronic device 100.

Refer to FIG. 1 and FIG. 5. FIG. 5 is a diagram of a heat dissipation principle of the vapor chamber 20. In FIG. 5, a first area 21 and a second area 22 are used as an example to describe the heat dissipation principle of the vapor chamber 20. A third area is not shown in FIG. 5. It may be understood that, for heat dissipation principles of the first area 21 and the third area, refer to the first area 21 and the second area 22. A black arrow in the vapor chamber 20 in FIG. 5 represents a flow direction of liquid, and a white arrow in the vapor chamber 20 in FIG. 5 represents a flow direction of gas.

The vapor chamber 20 may include the first area 21, the second area 22, and the third area 23. The first area 21 may be fastened to the heating element 10. It may be understood that the first area 21 may be in contact with and fastened to the heating element 10. Alternatively, another mechanical part (for example, the fastener 106) may be disposed between the first area 21 and the heating element 10, and the first area 21 is connected to the heating element 10 via the another mechanical part.

In some embodiments, the first area 21 is used for heat absorption, the second area 22 and the third area 23 may be disposed away from the heating element 10 relative to the first area 21, and the second area 22 and the third area 23 are used for heat dissipation, that is, the second area 22 and the third area 23 dissipate the heat energy of the heating element 10. The first area 21, the second area 22, and the third area 23 may be in a form of a "Y"-shaped structure, a "T"-shaped structure, or the like. The heat energy of the heating element 10 is transferred to the first area 21, the heat energy vaporizes a liquid working medium (the liquid working medium may be water) in the first area 21 into gas, and the gas diffuses and fills a cavity of the vapor chamber 20. After the gas is in contact with the second area 22 or the third area 23 with a low temperature, the gas is liquefied into liquid, and heat energy is dissipated, to dissipate heat for the heating element 10. The liquid liquefied in the second area 22 and the third area 23 flows back to the first area 21 under a capillary force of a capillary structure 26 in the vapor chamber 20, and continues to be vaporized in the first area 21 to form gas. The process is repeated to implement continuous heat dissipation.

In some embodiments, the heat dissipation fin 103 may be disposed outside the second area 22 or the third area 23. The air exhaust vent of the heat dissipation element (not shown in FIG. 5, shown in FIG. 4) faces the heat dissipation fin, and heat energy is taken away under an action of wind, to dissipate heat.

The second area 22 and the third area 23 may be disposed close to the air exhaust vent of the electronic device 100, to dissipate heat energy. For example, as shown in FIG. 1, the vapor chamber 20 is located in the first part 101, and the air exhaust vent is usually located in a top part 1011 of the first part 101. Therefore, the second area 22 and the third area 23 are disposed close to the top part 1011 of the first part 101. As shown in FIG. 2, the vapor chamber 20 is located in the second part 102, the air exhaust vent is usually disposed at a joint 1021 between the first part 101 and the second part 102, and the second area 22 and the third area 23 are disposed close to the joint 1021 between the first part 101 and the second part 102.

It may be understood that the second area 22 and the third area 23 of the vapor chamber 20 in FIG. 1 and FIG. 2 are arranged horizontally. In another implementation, alternatively, the second area 22 and the third area 23 of the vapor chamber 20 in FIG. 1 and FIG. 2 may be arranged vertically.

It may be understood that, in some embodiments, the vapor chamber 20 may not include the third area 23, and the vapor chamber 20 may have a plurality of structural forms. A specific structure of the vapor chamber 20 is not limited in embodiments of this application.

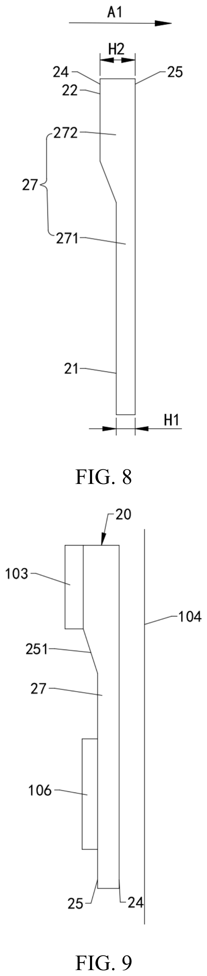

FIG. 6 is a diagram of a structure of the vapor chamber 20 shown in FIG. 1, FIG. 7 is a diagram of an exploded structure of the vapor chamber 20 shown in FIG. 6, and FIG. 8 is a side view of the vapor chamber 20 shown in FIG. 6. FIG. 8 is a simplified side view from a perspective of a side on which the second area 22 is located. The vapor chamber 20 includes a first cover plate 24, a second cover plate 25, and the capillary structure 26. The first cover plate 24 and the second cover plate 25 are arranged in a first direction A1, and an edge of the first cover plate 24 is fastened to an edge of the second cover plate 25, to form a closed cavity 27 between the first cover plate 24 and the second cover plate 25. For example, the first cover plate 24 and the second cover plate 25 may be fastened through welding. The capillary structure 26 is located in the cavity 27, and the capillary structure 26 is configured to guide flow of a liquid working medium in the cavity 27. In this embodiment of this application, the cavity 27 may have different thicknesses in different areas.

A material of the first cover plate 24 may be at least one of stainless steel, copper, and titanium, and a material of the second cover plate 25 may be at least one of stainless steel, copper, and titanium. For example, the first cover plate 24 may be made of stainless steel, or may be made of a composite material of stainless steel and copper, that is, copper is plated on a surface of the stainless steel. The material of the second cover plate 25 may be the same as or different from that of the first cover plate 24. In this embodiment of this application, the cavity 27 formed by the first cover plate 24 and the second cover plate 25 has different thicknesses in different areas. In other words, the first cover plate 24 or the second cover plate 25 is an uneven structure, the first cover plate 24 or the second cover plate 25 may be formed through stamping, and the first cover plate 24 or the second cover plate 25 needs to have high-strength performance. The material of the first cover plate 24 or the second cover plate 25 is set to at least one of high-strength stainless steel, copper, or titanium. This facilitates processing of the vapor chamber 20, and improves a manufacturing yield of the vapor chamber 20.

The capillary structure 26 may include a capillary mesh and a capillary fiber. The capillary mesh is configured to provide a capillary force for the capillary structure. The capillary mesh may be a porous structure, the capillary mesh may be a structure woven from a metal wire (for example, a copper wire), or may be a structure formed by sintering powder. A material, a structure, a formation manner, and the like of the capillary mesh are not limited in embodiments of this application. The capillary fiber may be configured to drain liquid and improve the capillary force of the capillary structure. There may be one layer, two layers, or the like of capillary meshes. In this embodiment of this application, an example in which there are two layers of capillary meshes and the two layers of capillary meshes are stacked is used. The two layers of capillary meshes are respectively a first capillary mesh 261 and a second capillary mesh 262. In this embodiment of this application, an example in which the capillary fibers are respectively a first capillary fiber 263 and a second capillary fiber 264 is used. The first capillary mesh 261 and the second capillary mesh 262 are stacked and fastened to the second cover plate 25. Both the first capillary fiber 263 and the second capillary fiber 264 are fastened to a side that is of the capillary mesh (specifically, the second capillary mesh 262) and that faces the first cover plate 24. The first capillary fiber 263 and the second capillary fiber 264 may be in contact with and fastened to the first cover plate 24.

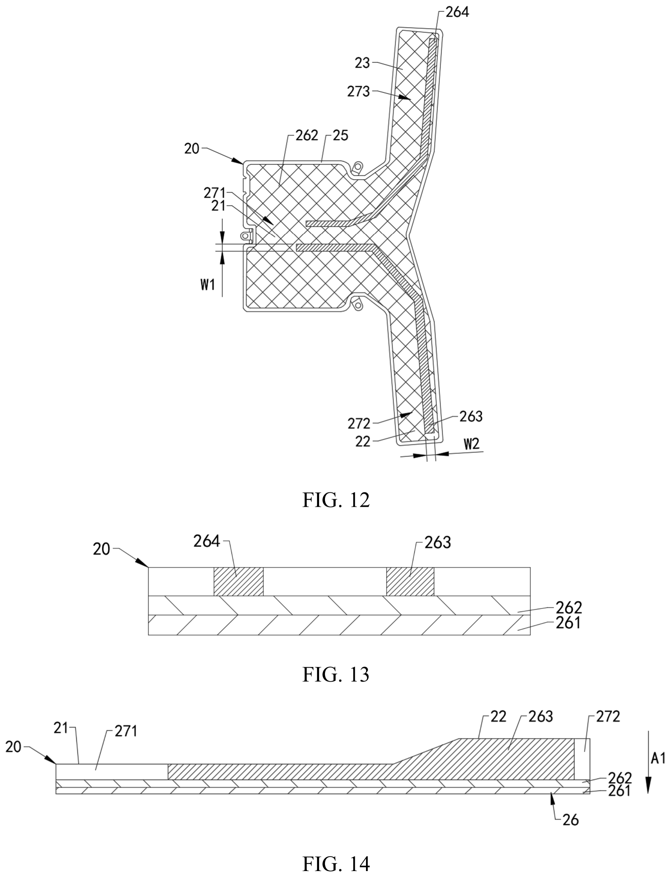

Refer to subsequent FIG. 12. In some embodiments, a part of the first capillary fiber 263 may be located in a second cavity 272 of the second area 22, and the other part of the first capillary fiber 263 may be located in a first cavity 271 of the first area 21, a part of the second capillary fiber 264 may be located in a third cavity 273 of the third area 23, and the other part of the second capillary fiber 264 may be located in the first cavity 271 of the first area 21. In another implementation, no capillary fiber may be disposed in the capillary structure.

In some embodiments, the first capillary mesh 261 and the second capillary mesh 262 may be pre-fastened to the second cover plate 25 through spot welding, and the first capillary fiber 263 and the second capillary fiber 264 are pre-fastened to the second capillary mesh 262 through spot welding, the first cover plate 24 and the second cover plate 25 are fastened through welding. After welding, the vapor chamber 20 is sintered at a high temperature, the first capillary mesh 261 and the second capillary mesh 262 are stably fastened to the second cover plate 25, and the first capillary fiber 263 and the second capillary fiber 264 are stably fastened between the second capillary mesh 262 and the first cover plate 24, to manufacture the vapor chamber 20.

As shown in FIG. 8, the cavity 27 may include a first cavity 271 and a second cavity 272 that communicate with each other. The first cavity 271 may be located in the first area 21, and the second cavity 272 may be located in the second area 22. A size H2 of the second cavity 272 in a first direction A1 is greater than a size H1 of the first cavity 271 in the first direction A1. It may be understood that the size of the cavity in the first direction A1 may be a spacing between structures that form the cavity and that are enclosed in the first direction A1. For example, the size H1 of the first cavity 271 in the first direction A1 may be a spacing that is between the first cover plate 24 and the second cover plate 25 and that corresponds to the first area 21 in the first direction A1; and the size H2 of the second cavity 272 in the first direction A1 may be a spacing that is between the first cover plate 24 and the second cover plate 25 and that corresponds to the second area 22 in the first direction A1. The size H1 of the first cavity 271 in the first direction A1 may be understood as that a thickness of the first cavity 271 is H1, and the size H2 of the second cavity 272 in the first direction A1 may be understood as that a thickness of the second cavity 272 is H2.

In this embodiment of this application, a thickness of the second cavity 272 is set to be greater than a thickness of the first cavity 271, that is, the cavity 27 is designed to have unequal thicknesses. Compared with a design in which a size of the first cavity 271 is equal to a size of the second cavity 272 in the first direction A1, in this embodiment of this application, a size of the second cavity 272 configured to dissipate heat for the heating element is increased, so that air resistance of the gas in the second cavity 272 is small, and a through-flow capability of the gas is increased. This facilitates timely and rapid diffusion of the gas to the second cavity 272, and helps improve heat dissipation efficiency of the vapor chamber 20, to improve a heat dissipation capability of the vapor chamber 20.

FIG. 9 is a diagram of a structure formed with the cavity 27 of the vapor chamber 20. The cavity 27 may be designed to have unequal thicknesses. The second cover plate 25 may be stamped to form a special-shaped structure (the special-shaped structure is relative to a plate-shaped structure), and is fastened to the plate-shaped first cover plate 24. Two parts of the second cover plate 25 are connected through an inclined plane 251, to facilitate stamping and molding, so that a wedge-shaped transition is formed between the first area 21 and the second area 22.

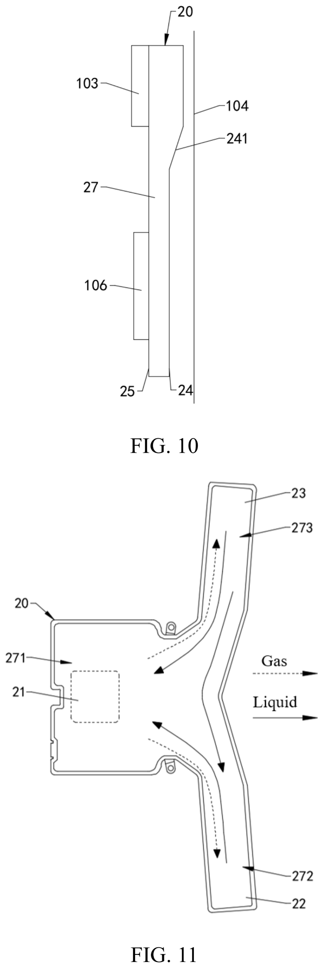

FIG. 10 is a diagram of another structure formed with the cavity 27 of the vapor chamber 20. The cavity 27 may be designed to have unequal thicknesses. The first cover plate 24 may be stamped to form a special-shaped structure (the special-shaped structure is relative to a plate-shaped structure), and is fastened to the plate-shaped second cover plate 25. Two parts of the first cover plate 24 are connected through an inclined plane 241, to facilitate stamping and molding, so that a wedge-shaped transition is formed between the first area 21 and the second area 22.

As shown in FIG. 3 and FIG. 11, FIG. 11 is a principle diagram of circulation of liquid and gas inside the vapor chamber 20. The liquid working medium in the first area 21 is vaporized into gas due to impact of heat energy of the heating element, and the gas may diffuse to the second area 22 and the third area 23 and fill the cavity of the vapor chamber 20. After the gas is in contact with the second area 22 and the third area 23 with a low temperature, the gas is liquefied into liquid, and heat energy is dissipated, to dissipate heat for the heating element 10. The liquid liquefied in the second area 22 and the third area 23 flows back to the first area 21 under a capillary force of a capillary structure in the vapor chamber 20, and continues to be vaporized in the first area 21 to form gas. The process is repeated to implement continuous heat dissipation. When the electronic device 100 is used, the electronic device 100 may be placed horizontally, placed vertically, or laid flat. A relative position of the vapor chamber 20 changes in different use scenarios. When the vapor chamber 20 is in the scenarios shown in FIG. 3 and FIG. 11, the second area 22 has an anti-gravity problem. It may be understood that, the liquid in the second area 22 needs to overcome gravity of the liquid, and flows back to the first area 21 under an action of the capillary force of the capillary structure. However, when the capillary force exerted on the liquid in the second area 22 is insufficient to overcome gravity of the liquid (that is, anti-gravity), the liquid in the second area 22 cannot flow back to the first area 21, the liquid accumulates in the second area 22, and consequently, a heat dissipation capability of the vapor chamber 20 is reduced. In addition, a part of liquid liquefied in the third area 23 flows back to the first area 21 under the action of gravity and the capillary force, and another part of liquid in the third area 23 also flows to the second area 22 under the action of gravity, causing liquid accumulation in the second area 2. It is difficult for the liquid in the second area 22 to flow back to the first area 21, and gas-liquid circulation in the second area 22 is blocked, thereby reducing a heat dissipation capability of the vapor chamber 20. Therefore, the anti-gravity problem existing in the second area 22 needs to be resolved.

In this embodiment of this application, structures of the vapor chamber 20 are described by using the following four solutions as examples, to resolve the anti-gravity problem of the vapor chamber 20 and improve the heat dissipation capability of the vapor chamber 20. It may be understood that the vapor chamber 20 may alternatively be a structure other than structures in the four solutions. A structure of the vapor chamber 20 is not limited in this application. The solution in this embodiment of this application includes but is not limited to changing a size of the capillary structure in the second area 22 to increase the capillary force of the capillary structure in the second area 22, increasing a quantity of capillary fibers in the second area 22 to increase the capillary force of the capillary structure in the second area 22, disposing a partition member 28, disposing the first capillary fiber 263 on a first side 221 with a lower temperature, and arranging the first capillary fiber 263 and the second capillary fiber 264 in a staggered manner.

Solution 1: As shown in FIG. 12, FIG. 13, and FIG. 14, FIG. 12 is a diagram of a partial structure of the vapor chamber 20 shown in FIG. 6. The structure in FIG. 12 is a diagram of a structure of the vapor chamber 20 in FIG. 6 with the first cover plate 24 being removed, to clearly show an internal structure of the vapor chamber 20. FIG. 13 is a diagram of a partial internal structure of the vapor chamber 20 shown in FIG. 6 from an angle, and FIG. 14 is a diagram of an internal structure of the vapor chamber 20 shown in FIG. 6 from another angle.

In some embodiments, in the first direction A1, a size of a part that is of the capillary structure 26 and that is located in the second area 22 is greater than a size of a part that is of the capillary structure 26 and that is located in the first area 21. In the first direction A1, the size of the part that is of the capillary structure 26 and that is located in the second area 22 may be understood as a thickness of the capillary structure in the second area 22. In the first direction A1, the size of the part that is of the capillary structure 26 and that is located in the first area 21 may be understood as a thickness of the capillary structure in the first area 21. In other words, the thickness of the capillary structure in the second area 22 is greater than the thickness of the capillary structure in the first area 21.

In this embodiment of this application, the thickness of the second cavity 272 is set to be greater than the thickness of the first cavity 271, so that space of the second cavity 272 is increased. A capillary structure with a thicker thickness may be disposed in the second cavity 272 with larger space, so that the thickness of the capillary structure in the second area 22 is greater than the thickness of the capillary structure in the first area 21, to increase a capillary force of the capillary structure in the second cavity 272. Liquid in the second cavity 272 can overcome gravity of the liquid to implement backflow even in an anti-gravity scenario, thereby improving a liquid backflow capability in the second cavity 272, and preventing liquid from accumulating in the second cavity 272. This resolves an anti-gravity problem, and improves heat dissipation efficiency and a heat dissipation capability of the vapor chamber 20.

In some embodiments, as shown in FIG. 14, in the first direction A1, a size of a part that is of the first capillary fiber 263 and that is in the second area 22 (that is, a thickness of the part that is of the first capillary fiber 263 and that is in the second area 22) may be set to be greater than a size of a part that is of the first capillary fiber 263 and that is in the first area 21 (that is, a thickness of the part that is of the first capillary fiber 263 and that is in the first area 21), to increase a thickness of a capillary structure of the second area 22. In this way, the thickness of the capillary structure in the second area 22 is greater than the thickness of the capillary structure in the first area 21. This helps provide a sufficient capillary force for liquid in the second cavity 272, facilitates liquid backflow, and resolves an anti-gravity problem.

In some embodiments, in the first direction A1, a size of a part of the capillary mesh in the second area 22 may be set to be greater than a size of a part of the capillary mesh in the first area 21, to increase a thickness of the capillary structure in the second area 22. In this way, the thickness of the capillary structure in the second area 22 is greater than the thickness of the capillary structure in the first area 21. This helps provide a sufficient capillary force for liquid in the second cavity 272, facilitates liquid backflow, and resolves an anti-gravity problem. For example, the first capillary mesh 261 and the second capillary mesh 262 are stacked. The capillary mesh herein is a structure with the first capillary mesh 261 and the second capillary mesh 262 being stacked. For example, a thickness of a part that is of the first capillary mesh 261 and that is in the second area 22 may be increased, a thickness of a part that is of the second capillary mesh 262 and that is in the second area 22 may also be increased, or both a thickness of a part that is of the first capillary mesh 261 and that is in the second area 22 and a thickness of a part that is of the second capillary mesh 262 and that is in the second area 22 may be increased. In another implementation, a quantity of layers of the capillary mesh in the second area 22 may also be increased.

In some embodiments, a width W2 of a part that is of the first capillary fiber 263 and that is located in the second area 22 is greater than a width W1 of a part that is of the first capillary fiber 263 and that is located in the first area 21. In this embodiment of this application, the width of the part that is of the first capillary fiber 263 and that is in the second area 22 may be increased to increase the capillary force of the capillary structure in the second area 22. This helps provide a sufficient capillary force for liquid in the second cavity 272, facilitates liquid backflow, and resolves the anti-gravity problem.

In some embodiments, when the vapor chamber 20 includes the third area 23, the third cavity 273 is located in the third area 23, the third cavity 273 communicates with the first cavity 271 the second cavity 272, gas can diffuse from the first cavity 271 to the second cavity 272 and the third cavity 273, and liquid can flow from the second cavity 272 and the third cavity 273 to the first cavity 271. A thickness of the third cavity 273 may be greater than or equal to a thickness of the first cavity 271.

In some embodiments, a thickness of a part that is of the capillary structure and that is located in the third area 23 may be greater than or equal to a thickness of a part that is of the capillary structure and that is located in the first area 21. When the thickness of the part that is of the capillary structure and that is located in the third area 23 is greater than the thickness of the part that is of the capillary structure and that is located in the first area 21, a thickness of a part that is of the capillary fiber and that is located in the third area 23 may be greater than a thickness of a part that is of the capillary fiber and that is located in the first area 21, or a thickness of a part that is of the capillary mesh and that is located in the third area 23 may be greater than a thickness of a part that is of the capillary mesh and that is located in the first area 21. A width of the part that is of the capillary fiber and that is located in the third area 23 may be greater than or equal to a width of the part that is of the capillary fiber and that is located in the first area 21.

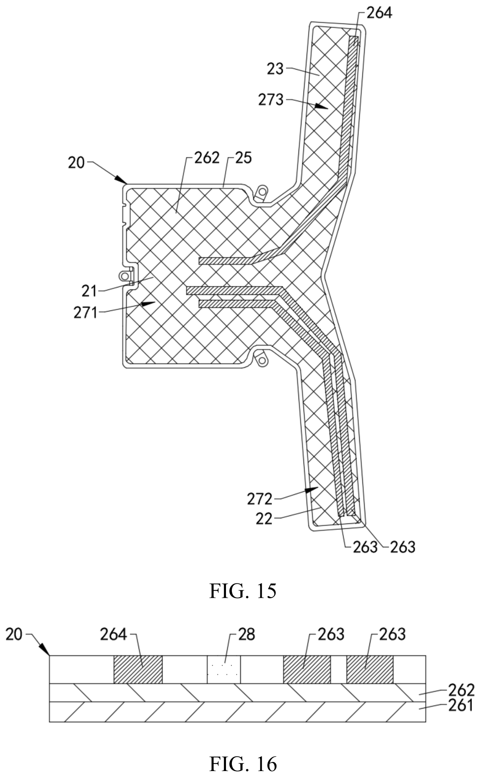

Solution 2: FIG. 15 is a diagram of a partial structure of another vapor chamber 20. The structure in FIG. 15 is a diagram of a structure of the vapor chamber 20 with the first cover plate 24 being removed, to clearly show an internal structure of the vapor chamber 20. FIG. 16 is a diagram of an internal structure of a vapor chamber 20.

In some embodiments, a quantity of first capillary fibers 263 in the second area may be greater than or equal to two. In this embodiment of this application, a quantity of capillary fibers in the second area 22 of the vapor chamber 20 may be increased to increase a capillary force of a capillary structure in the second area 22. This helps provide a sufficient capillary force for liquid in the second cavity 272, facilitates liquid backflow, and resolves the anti-gravity problem.

In some embodiments, when a third area 23 is disposed in the vapor chamber 20, a quantity of capillary fibers in the second area 22 may be greater than a quantity of capillary fibers in the third area 23. For example, there may be two first capillary fibers 263 in the second area 22, and there may be one second capillary fiber 264 in the third area 23. When there is an anti-gravity problem in the second area 22, the quantity of capillary fibers in the second area 22 is set to be greater than the quantity of capillary fibers in the third area 23. This helps provide a sufficient capillary force for liquid in the second cavity 272, facilitates liquid backflow, resolves the anti-gravity problem.

In some embodiments, the vapor chamber 20 may not include the third area 23, that is, the vapor chamber 20 is not provided with the third cavity 273. A specific structure of the vapor chamber 20 is not limited in embodiments of this application.

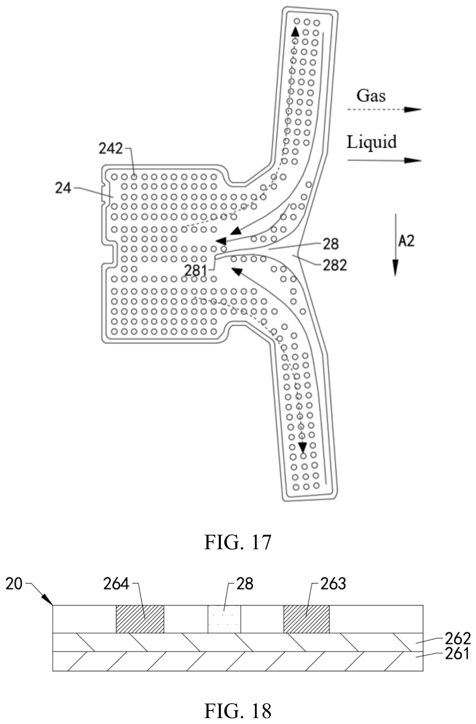

Solution 3: As shown in FIG. 11, FIG. 17, and FIG. 18, FIG. 17 is a diagram of a structure of the first cover plate 24, and FIG. 18 is a diagram of an internal structure of another vapor chamber 20.

The vapor chamber 20 may include a partition member 28, and the partition member 28 abuts between the second capillary mesh 262 and the first cover plate 24, that is, one side of the partition member 28 abuts against the first cover plate 24, and the other side of the partition member 28 abuts against the second capillary mesh 262. The partition member 28 is located between the second cavity 272 and the third cavity 273, that is, located between the second area 22 and the third area 23, and is configured to isolate the second cavity 272 from the third cavity 273.

The partition member 28 may be a hollow structure, to reduce a weight of the vapor chamber and implement lightweight. Alternatively, the partition member 28 may be a solid structure. In an anti-gravity scenario, when the second cavity 272 has an anti-gravity problem, a part of liquid in the third cavity 273 flows to the second cavity 272 under an action of gravity of the liquid. As a result, the liquid accumulates in the second cavity 272, it is more difficult for the liquid in the second cavity 272 to flow back, and a heat dissipation capability of the vapor chamber 20 is reduced. In this embodiment of this application, the partition member 28 is disposed between the second cavity 272 and the third cavity 273, to isolate the second cavity 272 from the third cavity 273, and to prevent liquid in the third cavity 273 from flowing to the second cavity 272. In this way, the liquid in the third cavity 273 flows back to the first cavity 271, and cyclic heat dissipation is implemented. In addition, the partition member 28 has a flow guiding function for the liquid in the third cavity 273.

In some embodiments, the partition member 28 and the first cover plate 24 are an integrated structure, and the partition member 28 and the first cover plate 24 are the integrated structure, so that a process of fastening the partition member 28 to the first cover plate 24 can be omitted; and the partition member 28 and the first cover plate 24 are the integrated structure, so that the first cover plate 24 and the partition member 28 are closely connected to each other. This prevents liquid in the third cavity 273 from flowing to the second cavity 272 due to a gap generated because the first cover plate 24 and the partition member 28 are not tightly connected to each other. In another implementation, the partition member 28 and the first cover plate 24 are a split structure and are fastened to each other.

In some embodiments, a surface that is of the partition member 28 and that faces the second cavity 272 is an arc-shaped surface; or a surface that is of the partition member 28 and that faces the third cavity 273 is an arc-shaped surface; or a surface that is of the partition member 28 and that faces the second cavity 272 may be set as an arc-shaped surface, and a surface that is of the partition member 28 and that faces the third cavity 273 may be set as an arc-shaped surface. When the surface that is of the partition member 28 and that faces the third cavity 273 is an arc-shaped surface, liquid in the third cavity 273 may flow to the first cavity 271 along the arc-shaped surface. This avoids a problem that, when the surface that is of the partition member 28 and that faces the third cavity 273 is a surface with a large bending angle, liquid accumulates seriously at the partition member 28 and cannot flow back to the first cavity 271 in time. In addition, the arc-shaped surface can reduce resistance to the gas, the surface of the second cavity 272 is an arc-shaped surface, and the surface that is of the partition member 28 and that faces the third cavity 273 is an arc-shaped surface. This can prevent the partition member 28 from affecting diffusion of gas, to affect heat dissipation effect of the vapor chamber.

In some embodiments, as shown in FIG. 11 and FIG. 17, the partition member 28 includes a first end 281 and a second end 282 that are disposed opposite to each other. The first end 281 is closer to the first area 21 than the second end 282, and the second end 282 is fastened to an inner side wall of the first cover plate 24. A size of the first end 281 in a second direction A2 is less than a size of the second end 282 in the second direction A2, and the second direction A2 is perpendicular to the first direction A1. A width of the first end 281 is smaller than a width of the second end 282. This helps liquid quickly flow to the first end 281 along the second end 282 and converge in the first area 21, and helps improve a heat dissipation capability of the vapor chamber 20.

As shown in FIG. 11 and FIG. 17, a support column 242 may be disposed on the first cover plate 24, one end of the support column 242 abuts against a side that is of the first cover plate 24 and that faces the second cover plate 25, and the other end of the support column 242 abuts against the second capillary mesh 262, to support a stable and closed cavity 27 formed between the first cover plate 24 and the second cover plate 25. The support column 242 may enhance strength of the vapor chamber 20. There may be a plurality of support columns 242, and the plurality of support columns 242 may be arranged based on a size and a shape of the vapor chamber. For example, the support columns 242 may be arranged in an array, or may be arranged irregularly, a large quantity of support columns 242 may be distributed in a central area of the vapor chamber 20, and a small quantity of support columns 242 may be distributed in an edge area of the vapor chamber 20. A form of the support column 242 is not limited to a cylindrical structure, and the support column 242 may alternatively be a strip structure.

In some embodiments, the first capillary fiber 263 and the second capillary fiber 264 are arranged with the support column 242 and the partition member 28 in a staggered manner. For example, the first capillary fiber 263 and the second capillary fiber 264 may be distributed in gaps of the plurality of support columns 242, and the first capillary fiber 263 and the second capillary fiber 264 may be spaced from the partition member 28.

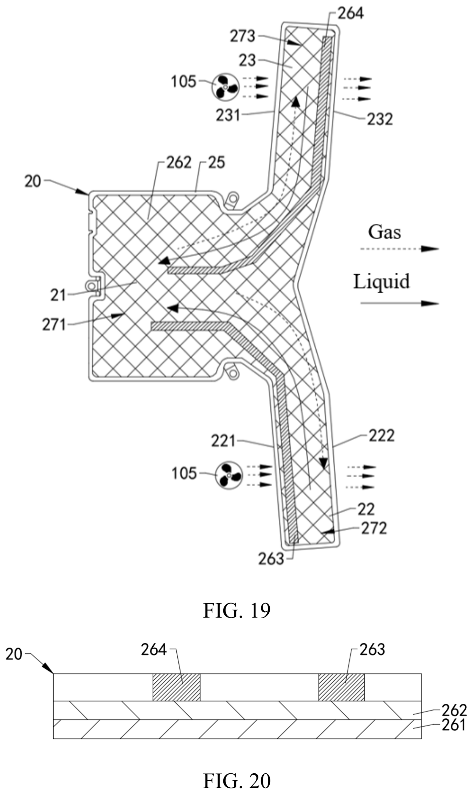

Solution 4: FIG. 19 is a diagram of a partial structure of another vapor chamber 20. The structure in FIG. 19 is a diagram of a structure of the vapor chamber 20 with the first cover plate 24 being removed, to clearly show an internal structure of the vapor chamber 20. FIG. 20 is a diagram of an internal structure of a vapor chamber 20. It may be understood that a difference between FIG. 20 and FIG. 13 lies in that the first capillary fiber 263 in FIG. 20 is closer to the right side.

The second area 22 may include a first side 221 and a second side 222, a temperature of the first side 221 is lower than a temperature of the second side 222, and a part that is of the first capillary fiber 263 and that is located in the second area 22 is located on the first side 221. The first side 221 is closer to the first area 21 than the second side 222. A heat dissipation element 105 is usually disposed in the electronic device. The heat dissipation element 105 is disposed on the first side 221, and blows heat energy to the second side 222, to keep the heat energy away from the vapor chamber 20. Therefore, the temperature of the first side 221 is lower than the temperature of the second side 222. In an anti-gravity scenario, when the second cavity 272 has an anti-gravity problem, the part that is of the first capillary fiber 263 and that is located in the second area 22 is disposed on the first side 221 with a lower temperature, to facilitate rapid backflow of liquid in the second cavity 272, and to prevent liquid from accumulating in the second cavity 272. This can effectively resolve the anti-gravity problem. It may be understood that, compared with the second side 222 with a higher temperature, the gas is more likely to be liquefied into liquid on the first side 221 with the lower temperature. The part that is of the first capillary fiber 263 and that is located in the second area 22 is disposed on the first side 221 on which the gas is more likely to be liquefied, the liquid liquefied on the first side 221 can quickly flow back to the first cavity 271 in time.

In some embodiments, the third area 23 may include a third side 231 and a fourth side 232, a temperature on the third side 231 is lower than a temperature on the fourth side 232, and a part that is of the second capillary fiber 264 and that is located in the third area 23 is located on the fourth side. The third side 231 is closer to the first area 21 than the fourth side 232. A heat dissipation element 105 is usually disposed in the electronic device. The heat dissipation element 105 is disposed on the third side 231, and blows heat energy to the second side 222, to keep the heat energy away from the vapor chamber 20. The part that is of the first capillary fiber 263 and that is located in the second area 22 is located on the first side 221 with the lower temperature, and the part that is of the second capillary fiber 264 and that is located in the third area 23 is located on the fourth side 232 with a higher temperature, so that the first capillary fiber 263 and the second capillary fiber 264 are arranged in a staggered manner, and the second capillary fiber 264 isolates the second cavity 272 from the third cavity 273. This prevents a part of liquid in the third cavity 273 from flowing to the second cavity 272, helps the liquid in the third cavity 273 flow back to the first cavity 271, and improves a heat dissipation capability of the vapor chamber 20. In addition, the first capillary fiber 263 and the second capillary fiber 264 are arranged in a staggered manner, to isolate the second cavity 272 from the third cavity 273. This facilitates completion of a vacuumizing process, can improve a vacuum degree in the cavity, and improve a heat dissipation capability of the vapor chamber.

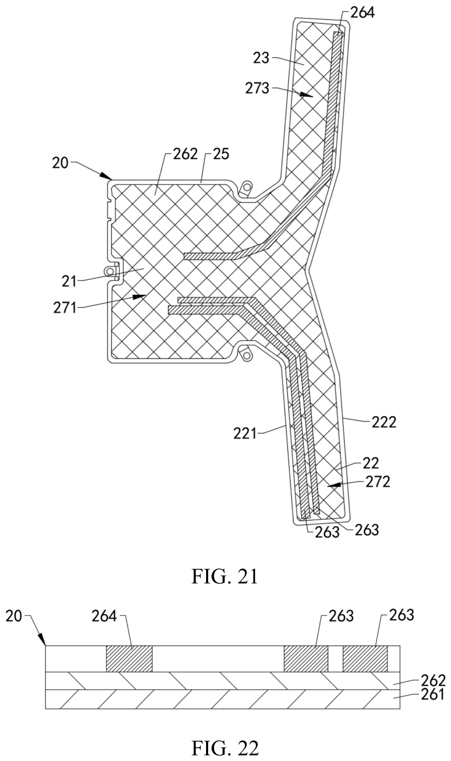

FIG. 21 is a diagram of a partial structure of another vapor chamber 20. The structure in FIG. 21 is a diagram of a structure of the vapor chamber 20 with the first cover plate 24 being removed, to clearly show an internal structure of the vapor chamber 20. FIG. 22 is a diagram of an internal structure of a vapor chamber 20. When there are two first capillary fibers 263 in the second area 22, both the two first capillary fibers 263 may be disposed close to the first side 221, so that liquid liquefied on the first side 221 quickly flows back to the first cavity 271 in time.

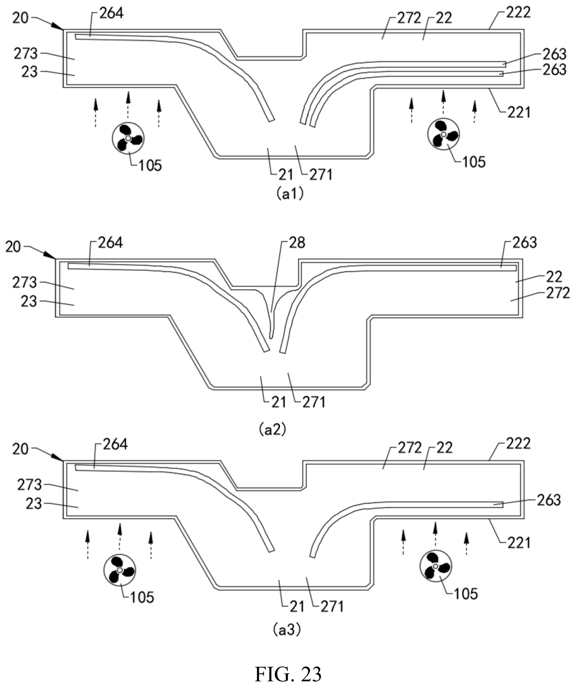

FIG. 23 is a diagram of a structure of another vapor chamber 20. (a1) in FIG. 23 shows that a thickness of the second cavity 272 is greater than a thickness of the first cavity 271, two first capillary fibers 263 are disposed in the second area 22, and both the two first capillary fibers 263 may be disposed close to the first side 221 with a lower temperature, so that liquid liquefied on the first side 221 quickly flows back to the first cavity 271 in time. (a2) in FIG. 23 shows that the thickness of the second cavity 272 is greater than the thickness of the first cavity 271, the partition member 28 is disposed, to isolate the second cavity 272 from the third cavity 273, and to prevent the liquid in the third cavity 273 from flowing to the second cavity 272. In this way, the liquid in the third cavity 273 flows back to the first cavity 271, and cyclic heat dissipation is implemented. (a3) in FIG. 23 shows that the thickness of the second cavity 272 is greater than the thickness of the first cavity 271, and the first capillary fiber 263 is disposed on the first side 221 with a lower temperature, to facilitate rapid backflow of liquid in the second cavity 272, and to prevent liquid from accumulating in the second cavity 272. This can effectively resolve an anti-gravity problem. In addition, the first capillary fiber 263 and the second capillary fiber 264 are arranged in a staggered manner, to isolate the second cavity 272 from the third cavity 273. This facilitates completion of a vacuumizing process, and can improve a vacuum degree in the cavity.

A difference between (a1) in FIG. 23, (a2) in FIG. 23, and (a3) in FIG. 23 and the foregoing embodiment lies in that external forms of the vapor chamber 20 are different. The vapor chamber 20 in the foregoing embodiment is Y-shaped, and the vapor chamber in FIG. 23 is T-shaped. The vapor chamber 20 in this embodiment of this application may have a plurality of shapes. This is not limited in this application. The vapor chamber 20 in FIG. 23 may also resolve a heat dissipation problem of the vapor chamber 20 by using a design other than designs in (a1) in FIG. 23, (a2) in FIG. 23, and (a3) in FIG. 23.

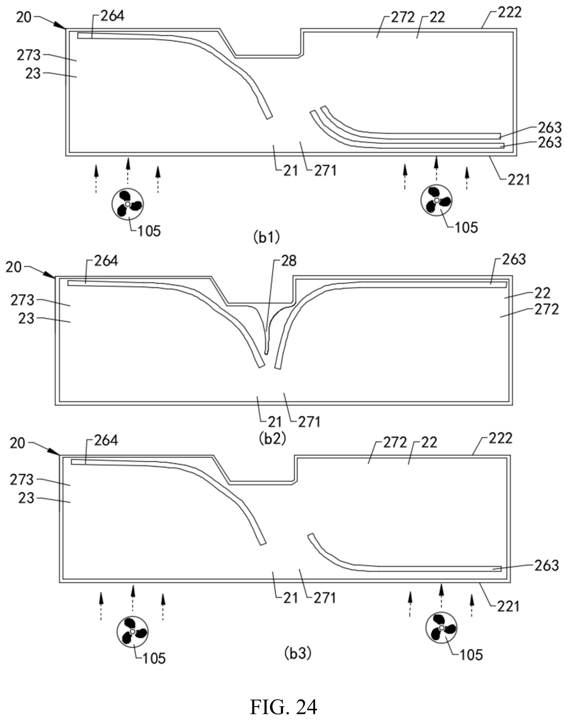

FIG. 24 is a diagram of a structure of another vapor chamber 20. (b1) in FIG. 24 shows that a thickness of the second cavity 272 is greater than a thickness of the first cavity 271, two first capillary fibers 263 are disposed in the second area 22, and both the two first capillary fibers 263 may be disposed close to the first side 221 with a lower temperature, so that liquid liquefied on the first side 221 quickly flows back to the first cavity 271 in time. (b2) in FIG. 24 shows that the thickness of the second cavity 272 is greater than the thickness of the first cavity 271, the partition member 28 is disposed, to isolate the second cavity 272 from the third cavity 273, and to prevent the liquid in the third cavity 273 from flowing to the second cavity 272. In this way, the liquid in the third cavity 273 flows back to the first cavity 271, and cyclic heat dissipation is implemented. (b3) in FIG. 24 shows that the thickness of the second cavity 272 is greater than the thickness of the first cavity 271, and the first capillary fiber 263 is disposed on the first side 221 with a lower temperature, to facilitate rapid backflow of liquid in the second cavity 272, and to prevent liquid from accumulating in the second cavity 272. This can effectively resolve an anti-gravity problem. In addition, the first capillary fiber 263 and the second capillary fiber 264 are arranged in a staggered manner, to isolate the second cavity 272 from the third cavity 273. This facilitates completion of a vacuumizing process, and can improve a vacuum degree in the cavity.

A difference between (b1) in FIG. 24, (b2) in FIG. 24, and (b3) in FIG. 24 and the foregoing embodiment lies in that external forms of the vapor chamber 20 are different, the vapor chamber 20 in FIG. 24 is in a square shape as a whole (it may be understood that the square may be a rectangle or a square, and a notch may be disposed on the square vapor chamber 20 as required). The vapor chamber 20 in this embodiment of this application may have a plurality of shapes. This is not limited in this application. The vapor chamber 20 in FIG. 24 may also resolve a heat dissipation problem of the vapor chamber 20 by using a design other than designs in (b1) in FIG. 24, (b2) in FIG. 24, and (b3) in FIG. 24.

In this embodiment of this application, the thickness of the second cavity 272 is set to be greater than the thickness of the first cavity 271, that is, the cavity 27 is designed to have unequal thicknesses. A size of the second cavity 272 configured to dissipate heat for the heating element is increased, so that air resistance of the gas in the second cavity 272 is small, and a through-flow capability of the gas is increased. This facilitates timely and rapid diffusion of the gas to the second cavity 272, and helps improve heat dissipation efficiency of the vapor chamber 20, to improve a heat dissipation capability of the vapor chamber 20. In this embodiment of this application, a partial size of the capillary structure in the second area 22 is set to increase the capillary force of the capillary structure in the second area 22, a quantity of capillary fibers in the second area 22 is increased to increase a capillary force of the capillary structure in the second area 22, the partition member 28 is disposed, the first capillary fiber 263 is disposed on the first side 221 with a lower temperature, the first capillary fiber 263, and the second capillary fiber 264 are arranged in a staggered manner, and the like, so that a problem of poor heat dissipation of the vapor chamber 20 in an anti-gravity scenario can be resolved, heat dissipation efficiency and a heat dissipation capability of the vapor chamber 20 are improved. It may be understood that the vapor chamber 20 in this embodiment of this application can achieve good heat dissipation effect on the heating element in both an anti-gravity scenario and a non-anti-gravity scenario, and the user can obtain good use experience in any use scenario.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A vapor chamber, used in an electronic device, and comprising a first cover plate, a second cover plate, and a capillary structure, wherein
an edge of the first cover plate is fastened to an edge of the second cover plate, to form a closed cavity between the first cover plate and the second cover plate;
the capillary structure is located in the cavity, and the capillary structure is configured to guide flow of liquid in the cavity;
the cavity comprises a first cavity and a second cavity that communicate with each other, the first cavity is located in a first area of the vapor chamber, the second cavity is located in a second area of the vapor chamber, and the first area is used to connect to a heating element of the electronic device; and
a size of the second cavity in a first direction is greater than a size of the first cavity in the first direction, and the first direction is an arrangement direction of the first cover plate and the second cover plate.

2. The vapor chamber according to claim 1, wherein in the first direction, a size of a part that is of the capillary structure and that is located in the second area is greater than a size of a part that is of the capillary structure and that is located in the first area.

3. The vapor chamber according to claim 1 or 2, wherein the capillary structure comprises a capillary mesh and a capillary fiber, the capillary mesh is fastened to the second cover plate, and the capillary fiber is fastened to a side that is of the capillary mesh and that faces the first cover plate; and
in the first direction, a size of a part that is of the capillary fiber and that is located in the second area is greater than a size of a part that is of the capillary fiber and that is located in the first area; or in the first direction, a size of a part that is of the capillary mesh and that is located in the second area is greater than a size of a part that is of the capillary mesh and that is located in the first area.

4. The vapor chamber according to claim 1 or 2, wherein the capillary structure comprises a capillary mesh and a capillary fiber, the capillary mesh is fastened to the second cover plate, the capillary fiber is fastened to a side that is of the capillary mesh and that faces the first cover plate, and a width of a part that is of the capillary fiber and that is in the second area is greater than a width of a part that is of the capillary fiber and that is in the first area.

5. The vapor chamber according to claim 1, wherein the capillary structure comprises a capillary mesh and a capillary fiber, the capillary mesh is fastened to the second cover plate, the capillary fiber is fastened to a side that is of the capillary mesh and that faces the first cover plate, and a quantity of capillary fibers in the second area is greater than or equal to two.

6. The vapor chamber according to any one of claims 1 to 5, wherein the cavity comprises a third cavity, the third cavity communicates with the first cavity and the second cavity, and the third cavity is located in a third area of the vapor chamber; and
the vapor chamber comprises a partition member, and the partition member is located between the second cavity and the third cavity and is configured to isolate the second cavity from the third cavity.

7. The vapor chamber according to claim 6, wherein a surface that is of the partition member and that faces the second cavity is an arc-shaped surface, or a surface that is of the partition member and that faces the third cavity is an arc-shaped surface.

8. The vapor chamber according to claim 7, wherein the partition member comprises a first end and a second end that are disposed opposite to each other, the first end is closer to the first area than the second end, a size of the first end in a second direction is less than a size of the second end in the second direction, and the second direction is perpendicular to the first direction.

9. The vapor chamber according to any one of claims 6 to 8, wherein the capillary structure comprises the capillary mesh and the capillary fiber, the capillary mesh is fastened to the second cover plate, the capillary fiber is fastened to the side that is of the capillary mesh and that faces the first cover plate, one side of the partition member abuts against the first cover plate, and the other side of the partition member abuts against the capillary mesh.

10. The vapor chamber according to claim 9, wherein the partition member and the first cover plate are an integrated structure.

11. The vapor chamber according to claim 1, wherein the capillary structure comprises a capillary mesh and a first capillary fiber, the capillary mesh is fastened to the second cover plate, the first capillary fiber is fastened to a side that is of the capillary mesh and that faces the first cover plate, and at least a part of the first capillary fiber is located in the second area; and
the second area comprises a first side and a second side, a temperature on the first side is lower than a temperature on the second side, and a part that is of the first capillary fiber and that is located in the second area is located on the first side.

12. The vapor chamber according to claim 11, wherein the cavity comprises a third cavity, the third cavity communicates with the first cavity and the second cavity, and the third cavity is located in a third area of the vapor chamber;
the capillary structure further comprises a second capillary fiber, and at least a part of the second capillary fiber is located in the third area; and
the third area comprises a third side and a fourth side, a temperature on the third side is lower than a temperature on the fourth side, and a part that is of the second capillary fiber and that is located in the third area is located on the fourth side.

13. The vapor chamber according to claim 1, wherein a material of the first cover plate or the second cover plate is at least one of stainless steel, copper, and titanium.

14. The vapor chamber according to claim 1, wherein the first area is used for heat absorption, and the second area is used for heat dissipation.

15. An electronic device, comprising a heating element and the vapor chamber according to any one of claims 1 to 14, wherein the heating element is connected to the vapor chamber, and heat energy of the heating element is conducted to the vapor chamber.
